Europäisches Patentamt

European Patent Office

Office européen des brevets

(19)

(11) **EP 0 697 659 B1**

(12) **EUROPÄISCHE PATENTSCHRIFT**

(45) Veröffentlichungstag und Bekanntmachung des Hinweises auf die Patenterteilung:
**15.12.1999 Patentblatt 1999/50**

(51) Int Cl.6: **G06F 11/20**

(21) Anmeldenummer: **94112661.7**

(22) Anmeldetag: **12.08.1994**

(54) **Redundanz-Schaltungsanordnung für einen integrierten Halbleiterspeicher**

Redundancy circuit for an integrated circuit semiconductor memory

Circuit de redondance pour une mémoire à circuit intégré à semi-conducteur

(84) Benannte Vertragsstaaten:
**AT DE FR GB IE IT NL**

(43) Veröffentlichungstag der Anmeldung:
**21.02.1996 Patentblatt 1996/08**

(73) Patentinhaber: **SIEMENS AKTIENGESELLSCHAFT 80333 München (DE)**

(72) Erfinder:
• **Savignac, Dominique, Dr.rer.nat. D-85737 Ismaning (DE)**
• **Sommer, Diether, Dipl.-Phys. D-80469 München (DE)**
• **Kiehl, Oliver, Dr.-Ing. D-80798 München (DE)**

(56) Entgegenhaltungen:
**US-A- 5 293 339          US-A- 5 293 564**

**Beschreibung**

Die Erfindung betrifft eine Redundanz-Schaltungsanordnung für einen integrierten Halbleiterspeicher wie er zum Beispiel aus IEEE Journal of Solid State Circuits, Vol. 26, Nr. 1, Januar 1991, Seite 12ff oder EP-A-0 472 209 bekannt ist, insbesondere für die Reparatur von Wortleitungen oder Bitleitungen bei dynamischen Speichern (DRAM).

Die Verkleinerung der Rastermaße bei jeder neuen Speichergeneration erhöht die Anfälligkeit für Defekte im Zellenfeld. Eine rentable Produktion erfordert daher Vorrichtungen auf dem Speicher, mit denen solche Defekte repariert werden können. In der Regel sind redundante Zellen vorgesehen, die mittels programmierbarer Codierungselemente anstelle von defekten Zellen eingesetzt werden.

Bei Speichern größerer Kapazitäten sind die Speicher in mehrere Blöcke unterteilt. Wegen der matrixförmigen Anordnung der Speicherzellen müssen die redundanten Zellen ebenfalls in Zeilen und Spalten angeordnet werden. Diese redundanten Leitungen sind im allgemeinen am Rande der Zellenfelder ausgebildet. Sie werden jeweils durch eine programmierbare Adreßschaltung im Zusammenhang mit den angelegten Adressen ausgewählt.

Diese programmierbaren Adreßschaltungen können zum Beispiel lasertrennbare Fuseblöcke sein. Üblicherweise wird jeder Fuseblock einer oder mehreren Leitungen fest zugeordnet. Im allgemeinen werden soviele Fuseblöcke und Adreßvergleicher benutzt wie die Anzahl der unabhängigen Speicherblöcke.

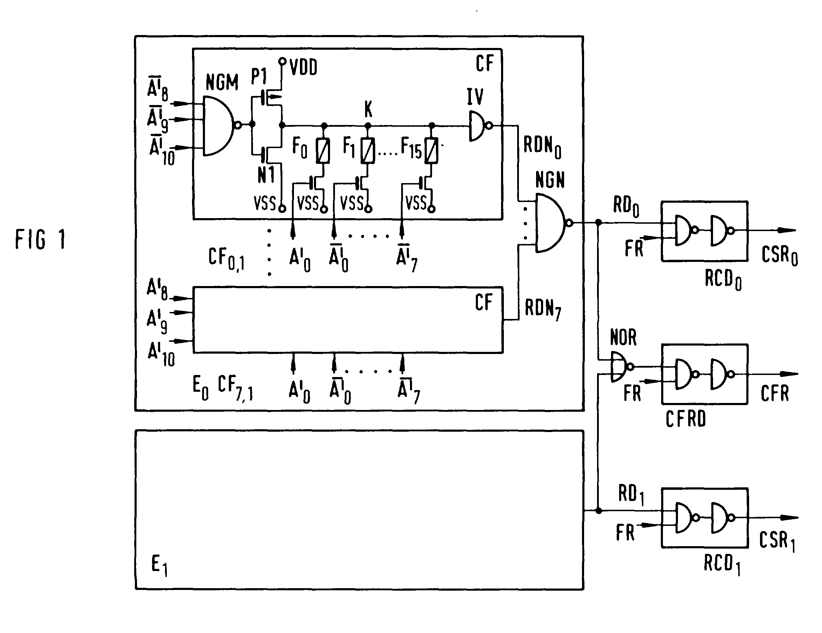

Figur 1 zeigt eine übliche Schaltung gemäß dem Stand der Technik zur Codierung der Spaltenadresse bei Spaltenredundanz. Als Beispiel sind die Speicherzellen hier in 8 Speicherblöcke aufgeteilt, die durch die Blockadresse $A'_8$, $A'_9$, $A'_{10}$ aufrufbar sind. Die Innenblockadresse $A'_{0...7}$, d. h. die Adresse einer Spalte innerhalb eines Speicherblocks, ist hier 8 Bits weit. Als Codierungselemente in den Adreßschaltungen CF werden hier lasertrennbare Fuseblöcke verwendet. Pro Fuseblock werden doppelt so viele trennbare Verbindungselemente $F_0,...F_{15}$ wie die Bitweite der Innenblockadresse benötigt.

In diesem Beispiel sind zwei redundante Spalten pro Speicherblock vorgesehen und werden von zwei Gruppen $E_0$, $E_1$ von Adreßschaltungen codiert, wobei nur eine Einheit Eg ausführlich gezeigt ist. Eine solche Einheit besteht aus acht identischen Adreßschaltungen $CF_{0,0}...CF_{7,0}$ bei Eg bzw. $CF_{0,1}...CF_{7,1}$ bei $E_1$ und aus einem NAND-Gatter NGN mit acht Eingängen $RDN_{0...7}$ und einem Ausgang $RD_0$ bei $E_0$ bzw. $RD_1$ bei $E_1$. In jeder Einheit Eg, $E_1$ ist jede Adreßschaltung $CF_{0,0...7,0}$ jeweils einem der acht Speicherblöcke zugeordnet. Die zwei Ausgangssignale $RD_0$ und $RD_1$ sind je einem redundanten Treiber $RCD_0$ bzw. $RCD_1$ mit den Ausgängen CSRO bzw. $CSR_1$ und einem NOR-Gatter NOR zugeführt. Der Ausgang dieses Gatters NOR ist an einem Treiber CFRD angeschlossen, dessen Ausgang mit CFR bezeichnet ist. Dieses Signal CFR wird dem normalen Spaltendecoder zugeführt und verriegelt den Spaltendecoder der normalen Speicherzellen, wenn ein redundanter Treiber ($RCD_0$ oder $RCD_1$) aktiviert ist. Die drei Treiber $RCD_0$, $RCD_1$ und CFRD sind an einem Freigabesignal FR angeschlossen, das bei einem Zustand log. "0" sowohl die normalen als auch die redundanten Auswahlleitungen auf niedrigerem Potential log. "0" halt. Dieses Freigabesignal FR wird üblicherweise für Synchronisationszwecke auf dem Chip verwendet.

Der Speicher ist in $2^3 = 8$ Speicherblöcken mit je $2^8 = 256$ Spalten von Speicherzellen pro Speicherblock organisiert. Jede Schaltung $CF_{ij}$ besitzt daher drei Eingänge für die Blockcodierung und einen Ausgang $RDN_i$, der mit einem Eingang des NAND-Gatters NGN verbunden ist.

Eine solche Schaltung $CF_{ij}$ besteht aus einem NAND-Gatter NGM mit drei Eingängen, aus einem nachgeschalteten Inverter P1, N1, aus $2\cdot8$ n-Kanal-Transistoren in Serie mit je einem Fuseelement, das am Ausgang A des Inverters P1, N1 parallel geschaltet ist und aus einem Ausganginverter IV. Die Blockauswahl geschieht über das Eingangs-NAND-Gatter NGM, dem zum Beispiel eine von allen möglichen Kombinationen von drei Leitungen aus den drei Block-Adreßleitungen $A'_{8,9,10}$ und ihrem komplementären Leitungen $\overline{A}_{8,9,10}$ zugeführt wird. Eine Schaltung $CF_{ij}$ wird dann aktiviert, wenn alle Eingange dieses NAND-Gatters log. "1" sind. Sein Ausgang ist dann log. "0" und der Ausgang K des Inverters P1, N1 demzufolge log. "1". Bei allen anderen Schaltungen CF ist mindestens ein Eingang $A'_m$ bzw. $\overline{A}'_m$ log. "0". Die Inverterausgange K sind demnach auch log. "0" und die Leitungen $RDN_n$ log. "1".

Wenn $Y' = 2^{N'}$ Auswahlleitungen vorhanden sind, werden $2\cdot N'$ Spalten-Adreßleitungen für die Codierung einer Spaltenadresse benötigt, ohne allgemeine Beschränkung, zum Beispiel $A'_{0...N'-1}$ bzw. $\overline{A}'_{0...N'-1}$, weil die Serienschaltung eines n-Kanal-Transistors und eines lasertrennbaren Fuseelements nur bei einem Eingangssignal mit log. "1" eine Wirkung zeigt.

Wenn bei der aktivierten Schaltung $CF_{i,j}$ mindestens ein Fuseelement, bei dem die entsprechende Spalten-Adreßleitungen den Zustand log. "1" hat, nicht getrennt ist, wird der Knoten K über diesen eingeschalteten n-Kanal-Transistor auf so niedrigem Potential gehalten, daß der Ausgangsinverter IV auf log. "1" schaltet. In diesem Fall haben demnach alle Leitungen $RDN_{0...7}$ den Zustand log. "1" und die Ausgangsleitung RDJ von NGN den Zustand log. "0". Die zugeordnete redundante Auswahl leitung CSRj ist also unabhängig vom Signal FR inaktiv, d. h. log. "0". Trifft dies bei beiden Leitungen $RD_0$ und $RD_1$, zu, ist der Ausgang des Gatters NOR log. "1". Wenn das Freigabesignal FR aktiv wird, nimmt das Signal CFR ebenfalls den Zustand log. "1" an, und entriegelt den normalen Spaltendecoder. In diesem Fall wird eine normale Bitleitungsgruppe selektiert.

Wenn im Gegensatz dazu bei einer aktiven Schaltung $CF_{i,0}$ oder $CF_{i,1}$ alle Fuseelemente aufgetrennt sind, bei denen die entsprechenden Spalten-Adreßleitungen log. "1" sind, bleibt der Knoten K auf hohem Potential geladen und der Ausgangsinverter IV bleibt im Zustand log. "0". Demzufolge nimmt eine Leitung $RD_1$ oder $RD_0$ den Zustand log. "1" an. Der Ausgang des Gatters NOR ist also log. "0". Dies gilt ebenfalls für das Signal CFR unabhängig vom Freigabesignal FR, so daß der normale Spaltendecoder verriegelt wird. Dagegen wird die redundante Auswahlleitung $CSR_0$ oder $CSR_1$ aktiviert und die entsprechende redundante Bitleitungsgruppe im aktiven Speicherblock $BK_i$ selektiert.

Ein Nachteil der beschriebenen Lösung ist, daß beim Anlegen einer nicht-programmierten Spaltenadresse, d. h. in Y'-1 Fällen von Y', im gesamten aktiven Zyklus ein Querstrom über den Transistor P1 der selektierten Schaltung $CF_{i,j}$ nach dem niedrigeren Potential fließt. Dieser Querstrom tritt eventuell zweimal bei jeder Speicherblockgruppe $E_1$, $E_0$ auf und nimmt bei konkreten Lösungen mit mehreren solchen Gruppen einen unzulässig hohen Wert an. Ein weiterer Nachteil ist, ebenfalls in konkreten Fällen, die zu hohe Zahl von Leitungen $RDN_{1...N}$ und das dadurch bedingte ungünstig große Ausgangsgatter NGN.

Ferner werden pro Adreßschaltung doppelt so viele trennbare Verbindungselemente benutzt, wie die Bitweite der Innenblockadresse beträgt. Die Ausführung der redundanten Adressendecoder hat zwei Nachteile: Erstens ist der Platzbedarf groß und kann daher zu einer Verringerung der Stückzahl von Chips pro Scheibe führen. Bei den derartigen Speichergenerationen ist die benötigte Fläche für die Fuseblöcke zusammen mit der der Ansteuerschaltungen in etwa so groß wie die Fläche, welche die redundanten Speicherzellen in Anspruch nehmen. Zweitens führt eine derartige Schaltung zu einem hohen Stromverbrauch, insbesondere bei Spaltenredundanz, wo die Ansteuerung der Spaltenredundanz im gesamten aktiven Zyklus betriebsbereit ist. Die Ausgangsleitungen werden dadurch auch stark belastet.

In der Druckschrift EP-A-0 492 099 wird eine Redundanz-Schaltungsanordnung beschrieben, wo die Innenblockadressen der zu ersetzenden Spalten oder Zeilen in Fuseblöcken programmiert werden, wobei nur so viele trennbare Verbindungen wie bei der Bitweite gebraucht werden. Diese Adressen werden durch einen lokalen Bus an die zugeordneten Redundanzdecoder in der Einschaltungsphase des Speichers eingeschrieben. In den Redundanzdecodern sind die Adressen der zu ersetzenden Spalten oder Zeilen durch Flip-Flop-Schaltungen gespeichert. Der Vergleich zwischen der angelegten Adresse und den Adressen der zu ersetzenden Spalten-Zeilen werden in jedem Redundanzdecoder getrennt ausgeführt. Daher wird zwar eine Ersparnis an der Anzahl von trennbaren Verbindungen erreicht, der Stromverbrauch bleibt aber hoch.

Aufgabe der vorliegenden Erfindung ist es, eine Implementierung der Spalten- oder Zeilenredundanz anzugeben, die einen minimalen Flächenbedarf der redundanten Adreßschaltungen aufweist, einen reduzierten Stromverbrauch und eine reduzierte Belastung der Adreßleitungen aufweist.

Die Erfindung wird anhand von 8 Figuren näher erläutert. Es zeigen:

| | |
|---|---|
| Figur 1 | eine Schaltungsanordnung für Adreßschaltungen und ihre Ansteuerung bei Spaltenredundanz gemäß dem Stand der Technik, |
| Figur 2 | ein Blockschaltbild einer erfindungsgemäß Zeilen-Redundanz-Schaltungsanordnung, |
| Figur 3 | ein Blockschaltbild einer erfindungsgemäßen Spalten-Redundanz-Schaltungsanordnung, |
| Figur 4 | eine Ausführungsform der Adreßschaltungen gemäß der vorliegenden Erfindung, |
| Figuren 5a-f | zwei Ausführungsformen des Adreßvergleichers bei Zeilenredundanz gemäß der vorliegenden Erfindung, |
| Figur 6 | eine Ausführungsform des Adreßvergleichers bei Spaltenredundanz gemäß der vorliegenden Erfindung, |
| Figur 7 | ein Zeitdiagramm der Signale der Schaltung gemäß den Figuren 2, 4 und 5, und |
| Figur 8 | ein Zeitdiagramm der Signale der Schaltung gemäß den Figuren 3, 4 und 6. |

Figur 2 zeigt ein Blockschaltbild einer erfindungsgemäß Ausführungsform der Redundanz-Schaltungsanordnung mit Zeilenredundanz. Die mit gestrichelten Linien begrenzten Bereiche IV und V sind in den Figuren 4 bzw. 5 ausführlicher gezeichnet.

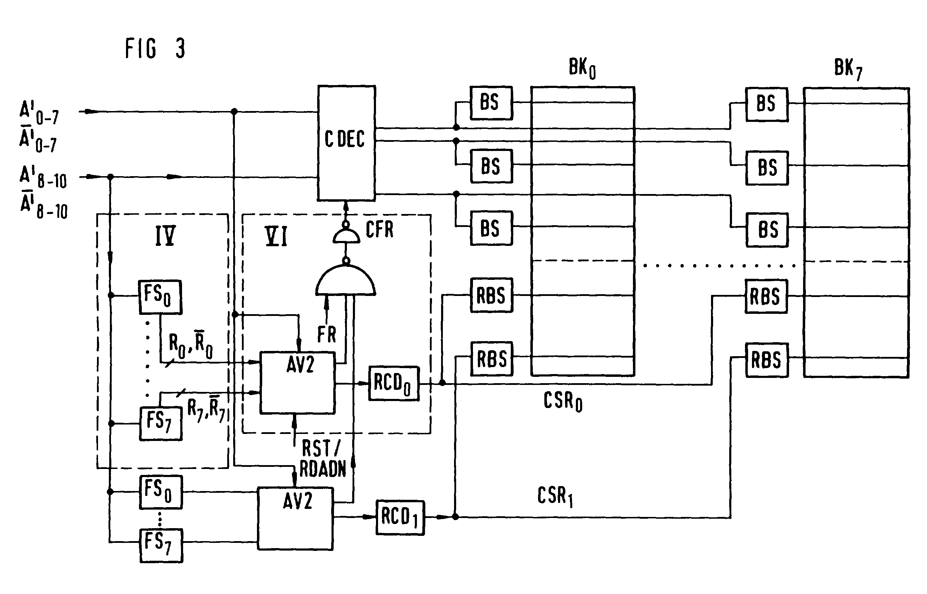

In Figur 3 ist ein Blockschaltbild einer Ausführungsform mit Spaltenredundanz dargestellt.

In den folgenden Beispielen sind die Schaltungen an einem ersten (VSS) und einem zweiten (VDD) Bezugspotential angeschlossen, welche beispielsweise Masse bzw. die Versorgungsspannung sein können.

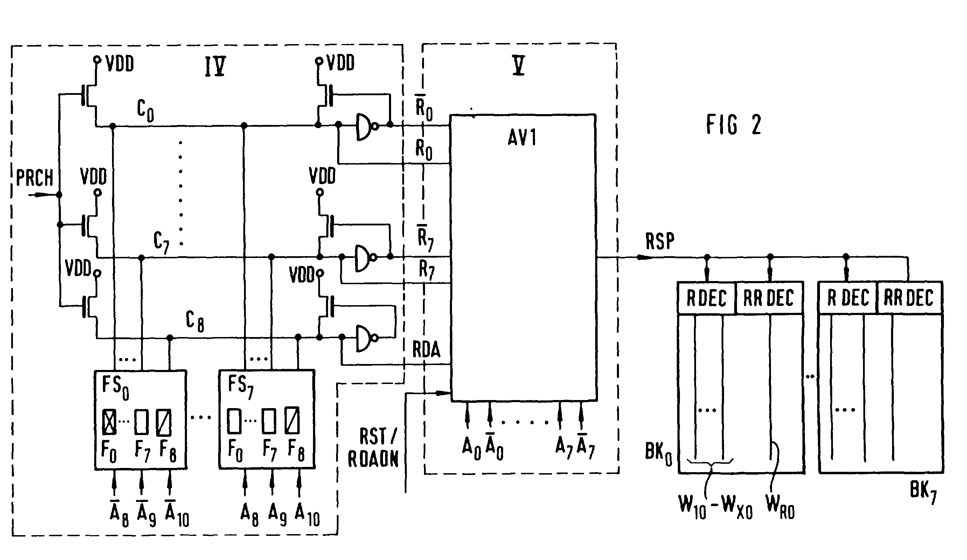

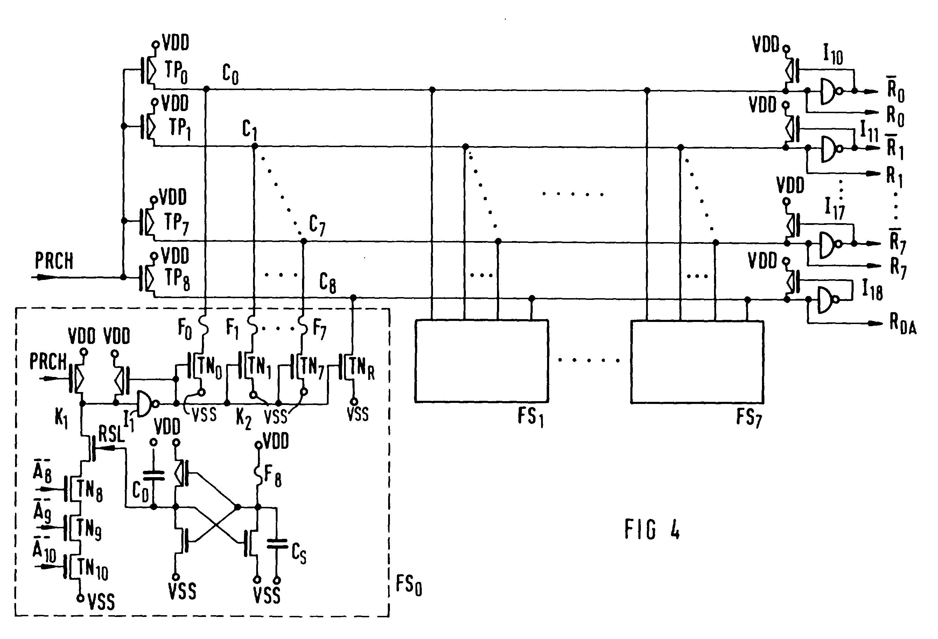

Die Adresse $R_{0-7}$, $\overline{R}_{0-7}$ einer zu ersetzenden Spalte oder Zeile werden in der Schaltung nach Figur 2 beispielsweise mittels eines lokalen Codierbus $C_{0-7}$ und einer solchen Anzahl von Adreßschaltungen $FS_0$ bis $FS_7$ programmiert, wie es der Anzahl a der unabhängigen Speicherblöcke BK0 bis BK7 entspricht. In Figur 4 ist die Adreßschaltung $FS_0$ ausführlich dargestellt. Als Beispiel sind hier a=8 Speicherblöcke BK0 bis BK7 gewählt. Die Innenblockadresse, d. h. die Adresse einer Spalte oder Zeile innerhalb eines Speicherblocks BK, ist hier acht Bits weit. Sie wird durch die trennbaren Ver-

bindungen $F_0$ bis $F_7$ codiert, die hier jeweils zwischen einem ersten Feldeffekttransistor $TN_{0...7}$ und einem ersten Knotenpunkt des Codierbusses angeschlossen ist. Eine zusätzliche Sicherung $F_8$ wird getrennt, wenn die Redundanz bei dem entsprechenden Speicherblock BK verwendet wird. Diese zusätzliche Sicherung $F_8$ ermöglicht, daß hier nur neun Sicherungen $F_0$ bis $F_8$ statt wie üblich sechzehn Sicherungen für die Adressierung nötig sind.

Im allgemeinen weist der Speicher a Speicherblöcke auf, wobei $a=2^M$ ist. Jeder der Speicherblöcke $BK_{0...7}$ weist Y' Spalten und Y Zeilen auf, wobei $Y=2^N$ und $Y'=2^{N'}$ sind. In diesem Fall werden N (N= die Bitweite der Innenblockadresse) Sicherungen für die Zeilen-Innenblockadresse benötigt. Die Speicherblöcke selbst sind durch 2·M Adreßleitungen adressierbar. Nachstehend werden mit A eine Zeilenadresse bezeichnet und mit A' eine Spaltenadresse. $\bar{A}$ bzw. $\bar{A}'$ bezeichnen die dazu komplementären Zeilen- bzw. Spaltenadressen.

Die in Figur 2 gezeigte Schaltung wird einmal pro redundante Leitung in jedem Speicherblock BK benötigt, im Gegensatz zu der in Figur 1 dargestellten Schaltung, wo eine Schaltung pro redundanter Leitung benötigt ist, d. h. in diesem Fall acht Schaltungen. Wenn in jedem Speicherblock BK zwei redundante Leitungen vorgesehen sind, werden zwei Schaltungen eingesetzt.

Wenn die trennbare Verbindung $F_8$ (siehe Figur 4) nicht unterbrochen ist, weist ein Bereitstellungssignal RSL das erste Bezugspotential VSS (Masse) auf. Die zwei Kapazitäten $C_S$ und $C_D$ der Adreßschaltung $FS_0$ in Figur 4 dienen zum sicheren Setzen des Bereitstellungssignals RSL auf das zweite Bezugspotential VDD, wenn die trennbare Verbindung $F_8$ getrennt ist.

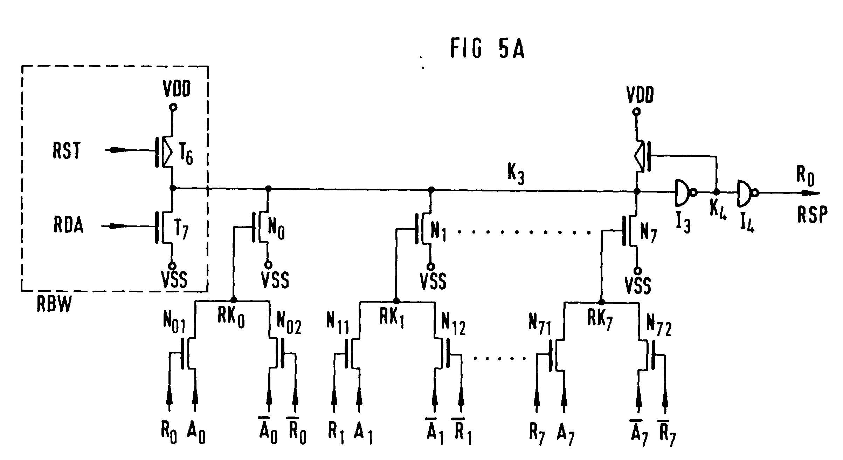

In der Adreßvergleicherschaltung AV1 in Figur 2 wird die angelegte Innenblockadresse $A_{0-7}$ mit der zu ersetzenden Adresse $R_{0-7}$ verglichen. In Figur 5a wird eine Ausführungsform der Schaltung des Adreßvergleichers AV1 gezeigt.

Im Unterschied zu der in Figur 1 gezeigten Schaltung, wo der Adreßvergleich an jeder Redundanzschaltung CF stattfindet, wird erfindungsgemäß der Vergleich mittels eines einzigen Adreßvergleichers AV1 durchgeführt. Der Adreßvergleich erfolgt jedoch nur dann, wenn in dem adressierten Block dessen zugehörige Adreßschaltung $FS_0$ bis $FS_7$ programmiert ist, so daß ein Aktivierungssignal RDA beispielsweise einen niedrigeren Pegel annimmt, d. h. wenn die angelegte Adresse einen Speicherblock BK betrifft, dessen Adreßschaltung (auch Fusebox genannt) $FS_0$ bis $FS_7$ programmiert ist. Dadurch werden die Innenblokkadreß-Leitungen $A_{0-7}$, $\overline{A_{0-7}}$ weniger belastet, und der Stromverbrauch der gesamten Speicherschaltung wird reduziert.

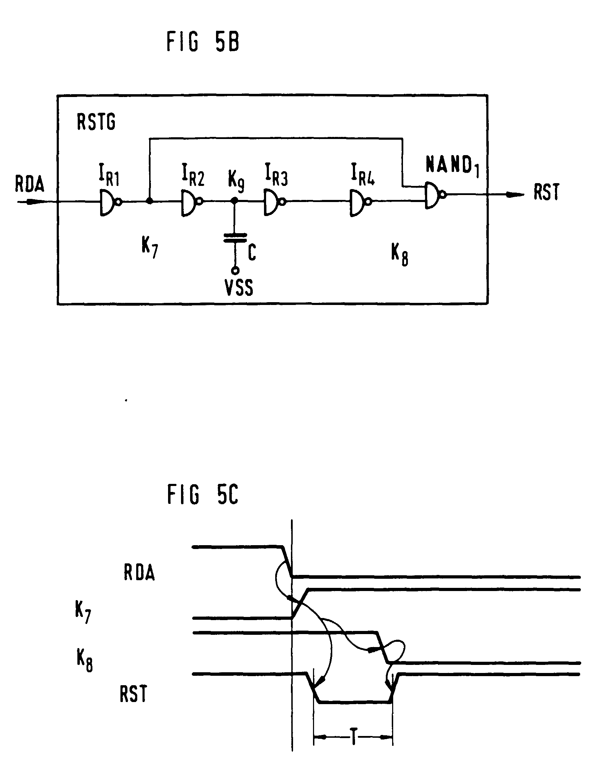

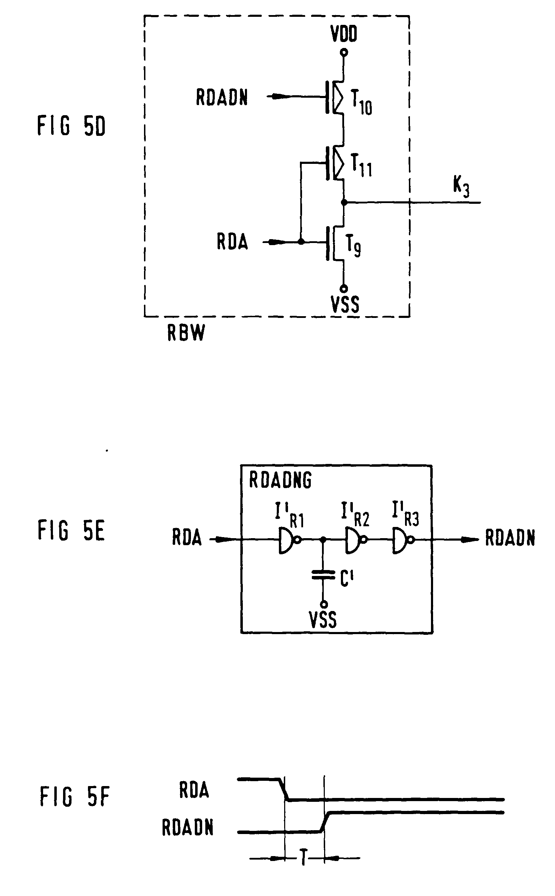

Der Adreßvergleicher AV1 in Figur 5a verwendet in einer Aktivierungsstufe RBW ein drittes Steuersignal RST in Form eines Pulssignals, das durch die in Figur 5b gezeigte Schaltung aus dem Aktivierungssignal RDA erzeugbar ist. In Figur 5d ist eine Schaltungsvariante der Aktivierungsstufe RBW angegeben, die ein verzögertes, viertes Steuersignal RDADN statt des Pulssignals RST benutzt. Diese Schaltung ist etwas schneller als die in Figur 5a gezeigte Schaltung. Durch ein derartiges Pulssignal RST oder ein verzögertes Signal RDADN wird der Stromverbrauch weiter reduziert.

Der Adreßvergleicher AV1 in Figur 5a verwendet in einer Aktivierstufe RBW ein drittes Steuersignal RST in Form eines Pulssignals, das durch die in Figur 5b gezeigte Schaltung aus dem Aktiviersignal erzeugbar ist. Die Aktivierstufe RBW in Figur 5a besteht aus einer Serienschaltung von einem sechsten und einem siebten FET T6, T7, wobei T6 ein p-Kanal- und T7 ein n-Kanal-FET ist. Die Signale RDA und RST sind an die Steuereingänge des siebten FETs T7 bzw. des sechsten FETs T6 angeschlossen.

Das dritte Steuersignal RST ist aus der in Figur 5b gezeigten Schaltung RSTG erzeugbar. Die Schaltung RSTG enthält eine Serienschaltung von vier aufeinanderfolgenden Inverterstufen $I_{R1}$-$I_{R4}$. Dem Eingang der Serienschaltung ist das Aktivierungssignal RDA zugeführt, und der Ausgang $K_8$ der Serienschaltung ist an einem NAND-Gatter $NAND_1$ angeschlossen. Der Knotenpunkt $K_7$ zwischen der ersten und zweiten Inverterstufe $I_{R1}$, $I_{R2}$ ist auch an dem NAND-Gatter $NAND_1$ angeschlossen. Ein Kondensator C ist zwischen dem ersten Bezeugspotential (Masse) und dem Knotenpunkt zwischen den zweiten und dritten Inverterstufen geschaltet. Das dritte Steuersignal RST ist das Ausgangssignal des NAND-Gatters $NAND_1$. Figur 5c zeigt ein Zeitdiagramm der Schaltung RSTG. Das dritte Steuersignal RST ist ein Puls der für ein Zeitintervall T auf log. "0" geht, wenn das Aktivierungssignal RDA auf log. "0" geht, und ansonsten weist der Pegel des dritten Steuersignals RST den Pegel log. "1" auf.

In Figur 5d ist eine Variante der Aktivierstufe RBW angegeben, die statt des dritten Steuersignals RST ein viertes Steuersignal RDADN benutzt. Statt eines Pulses wie RST ist RDADN ein Signal, das nach einem Zeitintervall T' nachem RDA auf log. "0" gesunken ist, den Pegel log. "1" ansteuert. Die Aktivierstufe RBW in Figur 5d enthält eine Serienschaltung von einem neunten, zehnten und elften Feldeffekttransistor $T_9$-$T_{11}$, wobei $T_9$ vom n-Kanal-Typ ist und die Transistoren $T_{10}$ und $T_{11}$ vom p-Kanal-Typ sind. Das Aktiviersignal RDA ist an die Steuereingänge der neunten und elften FETs $T_9$, $T_{11}$ angeschlossen und das vierte Steuersignal RDADN an den Steuereingang des zehnten FETs $T_{10}$.

Das dritte Steuersignal ist beispielsweise mit der in Figur 5E gezeigten Schaltung RDADNG erzeugbar. Sie enthält eine Serienschaltung von drei aufeinanderfolgenden Inverterstufen $I'_{R1}$ - $I'_{R3}$. Dem Eingang der Serienschaltung ist das Aktiviersignal RDA zugeführt, und am Ausgang der Serienschaltung entsteht das vierte Steuersignal RDADN. Ein Kondensator C' ist zwischen dem ersten Versorgungspotential (Mass) und dem Knotenpunkt zwischen der ersten und der zweiten Inverterstufe $I'_{R1}$, $I'_{R2}$ geschaltet. Figur 5f zeigt ein Zeitdiagramm der Schaltung RDADNG.

Wie Figur 2 zeigt, steuert das Ausgangssignal RSP des Adreßvergleichers AV1 bei Einsatz der Redundanz die redundanten Zeilendecoder RRDEC an und verriegelt gleichzeitig den normalen Zeilendecoder RDEC in jedem Speicherblock BK0 - BK7. Daher wird die redundante Zeile $W_{Rk}$ statt der zu ersetzenden Zeile $W_{ik}$ des Speicherblocks $BK_k$ adressiert.

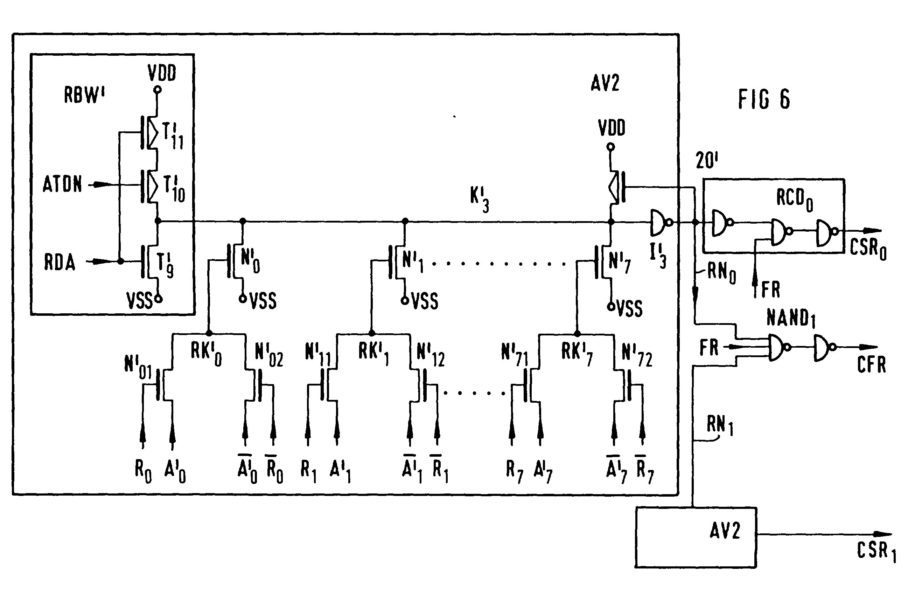

Figur 3 zeigt ein Blockschaltbild einer erfindungsgemäßen Ausführungsform der Redundanz-Schaltungsanordnung bei Spaltenredundanz. Die mit gestrichelten Linien begrenzten Bereiche IV und VI sind in den Figuren 4 bzw. 6 näher erläutert.

Die Funktion des Adreßvergleichers AV2 ist dieselbe wie bei dem in den Figuren 2 und 5a gezeigte Adreßvergleicher AV1. Im Vergleich zur Zeilenredundanz wird hier Zugriff auf ein viertes Steuersignal ATDN gemacht. Wie unten näher erläutert wird, hat das vierte Steuersignal ATDN die Funktion, Querströme durch den Adreßvergleicher AV2 zu vermeiden. In Figur 3 wird zusätzlich gezeigt, wie zwei Reihen von Adreß-Schaltungen FS0-FS7 und zwei Adreßvergleicher AV2 miteinander verbunden werden, wenn in jedem Block zwei redundante Spaltendecoder $RCD_0$ und $RCD_1$ mit den Auswahlleitungen CSR0 bzw. CSR1 verwendet werden. Die redundanten Spaltendecoder $RCD_0$ und $RCD_1$ steuern je einen redundanten Bitschalter RBS pro Speicherblock $BK_{0-7}$ an. Durch das Signal CFR wird bei Anwahl einer redundanten Spalte der normale Spaltendecoder CDEC verriegelt, so daß in diesem Fall die normalen Bitschalter BS nicht angesteuert werden.

Bei den in den beiden Figuren 5a und 6 gezeigten Adreßvergleicherschaltungen AV2 wird das Redundanzfreigabesignal CSR0 erst dann aktiviert, d. h. der dritte Knotenpunkt $K'_3$ ist log. "1", wenn alle Knoten $RK'_0$ bis $RK'_7$ log. "0" sind. Wenn mindestens einer dieser Knoten $RK'_0$ bis $RK'_7$ log. "1" ist, bleibt $K'_3$ über den eingeschalteten n-Kanal-Transistor $N'_0$ bis $N'_7$ auf so niedrigem Potential, daß der nachgeschaltete Inverter $I_3'$ den Ausgangspegel log. "1" behält.

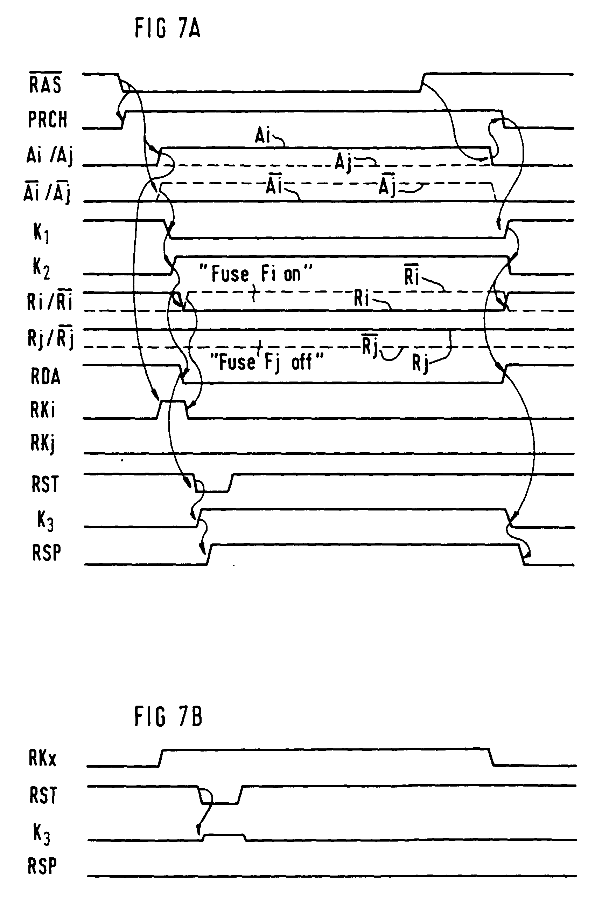

Die Funktion der Schaltung nach den Figuren 2, 4 und 5a wird anhand des Zeitdiagramms von Figur 7 erklärt, wobei nur die hierzu notwendigen Speichersignale dargestellt sind. Figur 7a zeigt einen Zyklus mit Einsatz der Zeilenredundanz, während Figur 7b den Normalfall zeigt, d. h. ohne Einsatz der Redundanz.

In der Ruhephase ($\overline{RAS}$=log. "1") sind die Adressen $A_{0-7}$ $\overline{A_{0-7}}$ und das zweite Steuersignal oder Ladesignal PRCH im Zustand log. "0". In diesem Zustand sind alle n-Kanal dritte Feldeffekt-Transistoren $N_{0-7}$ gesperrt und die p-Kanal zweiten Feldeffekt-Transistoren $TP_{0-8}$ leitend. Der Knoten $K_1$ ist demzufolge log. "1", und der Knoten $K_2$, welcher ein erstes Steuersignal den ersten Transistoren $TN_{0...7}$ und $TN_R$ liefert, ist log. "0". Die ersten Adreßausgänge $R_{0-7}$ und der erste Ausgang RDA des lokalen Codierungsbus $C_0$ bis $C_8$ sind

alle log. "1", während die zu ersten Adreßausgängen komplementären Ausgänge $\overline{R_{0-7}}$ log. "0" sind. Dadurch ist der dritte Knotenpunkt $K_3$ log. "0" und das Freigabesignal RSP log. "0".

Ein Schreib- oder Lese-Zyklus wird durch die fallende Flanke des Signals $\overline{RAS}$ eingeleitet. Das zweite Steuersignal PRCH wird nach der fallenden $\overline{RAS}$-Flanke log. "1".. Der Zustand log. "1" des Knoten $K_1$ bleibt durch den Rückhalt der geschalteten Inverter $I_1$ erhalten. Kurz danach wird eine bestimmte Kombination von Ausgangsleitungen $A_{0-10}$ und $\overline{A_{0-10}}$ aktiv . log. "1", wo $A_{0-7}$ und $\overline{A_{0-7}}$ die Innenblockadresse und $A_{8-10}$ und $\overline{A_{8-10}}$ die Blockadresse darstellen. Wenn zum Beispiel $\overline{A_8}$, $A_9$ und $\overline{A_{10}}$ alle log. "1" sind, wird der Speicherblock BK0 adressiert. Die drei n-Kanal-Transistoren $TN_8$ bis $TN_{10}$ der Adreßschaltung FS0 leiten daher. Die vierten Knotenpunkte $RK_i$ werden auf log. "1" geladen, wo $A_i$=log. "1", sonst sind $RK_j$ log. "0".

Wenn diese Adreßschaltung FS0 codiert ist, ist die Zusatzsicherung $F_8$ getrennt. Dadurch ist RSL auf log. "1". Der Knoten $K_1$ wird daher log. "0" und der Knoten $K_2$ log. "1". Die in Figur 4 dargestellte Ausführungsform der Adreßschaltung ist so geschaltet, daß eine aufgetrennte Sicherung $F_j$, j=0-7 eine log. "1" und eine intakte Sicherung $F_i$ log. "0" bedeutet. Durch den Codierungsbus $C_0$ bis $C_7$ wird die Adresse $R_{0-7}$, $\overline{R_{0-7}}$ der zu ersetzenden Zeile erzeugt. Gleichzeitig wird das Aktivierungssignal RDA log. "0" auf dem ersten Ausgang $C_8$ der Adreßschaltung erzeugt. Wenn alle $R_i$ und $A_i$ bzw. $\overline{R_i}$ und $\overline{A_i}$ (i=0...7) gleich sind, werden alle $RK_j$ log. "0". Alle dritten Feldeffekttransistoren (n-Kanal) $N_0$ bis $N_7$ sperren daher.

Durch die fallende RDA-Flanke wird der Puls RST erzeugt, welcher für ein Zeitintervall T log. "0" wird. Da alle dritten n-Kanal-Transistoren $N_{0-7}$ sperren, steigt der dritte Knotenpunkt $K_3$ auf log. "1". Durch die Haltestufe $I_3$, hier in Form eines rückhaltegeschalteten Inverters $I_3$, bleibt $K_3$ (auf log. "1") auch nachdem der Puls RST zurück auf log. "1" ist. Dadurch wird das Freigabesignal RSP, zur Ansteuerung der redundanten Dekoder log. "1".

Im Normalfall, d. h. wenn die Adressen $A_{0-7}$ und $R_{0-7}$ nicht übereinstimmen, ist mindestens eine $A_n \neq R_n$. Dadurch bleibt mindestens ein vierter Knotenpunkt $RK_n$ log. "1". Wenn das Pulssignal RST log. "0" wird, steigt zwar das Potential des dritten Knotenpunktes $K_3$, aber durch den leitenden n-Kanal-Transistor $N_n$ steigt das Potential nicht genügend, um den rückhaltegeschalteten Inverter $I_3$ umzuschalten. Daher bleibt $K_3$ auf log. "0" nach dem Puls RST, und das Freigabesignal RSP bleibt auf log. "0".

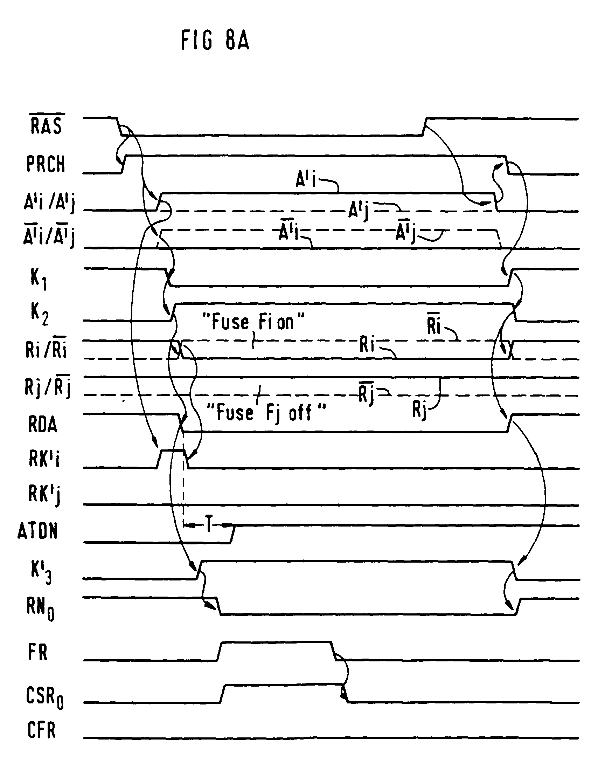

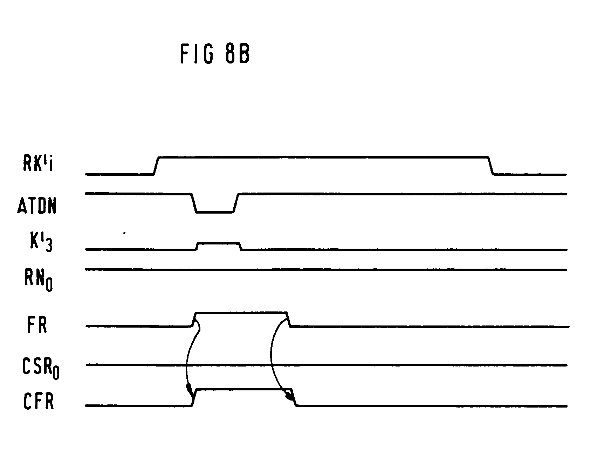

Die Funktion der in den Figuren 3, 4 und 6 gezeigten Redundanz-Schaltungsanordnung für die Spaltenredundanz wird anhand des Zeitdiagramms von Figur 8 erklärt, wobei nur die Unterschiede zum in Figur 3 dargestellten Zeitdiagramm beschrieben werden. Im Vergleich zu Figur 4 wird hier das dritte Steuersignal RST durch das vierte Steuersignal ATDN ersetzt, der wie RDADN aus dem Aktiviersignal RDA durch eine Schaltung nach Figur 5e erzeugt werden kann. Weiter wird auch ein bei sonstigen Teilschaltungen des Speichers bereits vorhandenes Datenfreigabesignal FR benutzt. CSRO ist ein Freigabesignal für einen redundanten Spaltendecoder RBS, und CFR ist ein Signal, das im Zustand log. "1" den normalen Spaltendecoder CDEC sperrt. CFR wird durch ein NAND-Gatter aus den Signalen RN0, RN1 erzeugt, d. h. CFR wird log. "1" wenn einer der redundanten Spaltendecodern eingeschaltet wird. Figur 8a zeigt - wie in Figuren 7a,b - ein Zeitdiagramm bei Redundanz und Figur 8b den "Normalfall".

In der Ruhephase ($\overline{RAS}$=log. "1") sind die Adressen $A'_{0-7}$ und $\overline{A'_{0-7}}$ und das zweite Steuersignal PRCH im Zustand log. "0". In diesem Zustand sind alle n-Kanal ersten Feldeffekttransistoren $N_{0-7}$ gesperrt und die p-Kanal zweiten Feldeffekttransistoren $TP_{0-8}$ leitend. Der Knoten $K_1$ ist demzufolge log. "1" und der Knoten $K_2$, welcher ein erstes Steuersignal an den ersten Transistor $TN_{0..7}$ und $TN_R$ liefert, ist log. "0". Der erste Adreßausgang $R_{0..7}$ und der erste Ausgang RDA der lokalen Codierungsbusse $C_0$ bis $C_8$ sind log. "1", während die zum ersten Adreßausgang komplementären Adreßausgänge $\overline{R_{0..7}}$ log. "0" sind. Dadurch ist der dritte Knotenpunkt $K'_3$ log. "1" und das Freigabesignal RN0 log. "1". Der redundante Bitdecoder $RCD_0$ ist daher verriegelt. Das Steuersignal CSRO bleibt dadurch auf log. "0", und die redundanten Bitschaltungen RBS bleiben daher verriegelt. Auch der normale Spaltendecoder CDEC ist durch CFR=log. "0" verriegelt.

Ein Schreib- oder Lesezyklus wird durch die fallende Flanke des Signals $\overline{RAS}$ eingeleitet. Das zweite Steuersignal PRCH wird nach der fallenden $\overline{RAS}$-Flanke log. "1". Der Zustand log. "1" des Knotens $K_1$ bleibt durch den rückhaltegeschalteten Inverter $I_1$ erhalten.

Kurz danach wird eine bestimmte Kombination von Ausgangsleitungen $A'_{0..10}$ und $\overline{A'_{0..10}}$ aktiv log. "1", wo $A'_{0..7}$ und $\overline{A'_{0..7}}$ die Innenblockadresse, und $A'_{8..10}$ und $\overline{A'_{8..10}}$ die Blockadresse darstellen. Die vierten Knotenpunkte $RK'_i$ werden auf log. "1" geladen, wo $A'_i$ log. "1" ist, sonst sind die vierten Knotenpunkte $RK'_j$=log. "0".

Wenn diese Adreßschaltung codiert ist, ist die Zusatzsicherung $F_8$ getrennt. Dadurch ist RSL auf log. "1". Der Knoten $K_1$ wird daher log. "0" und der Knoten $K_2$ log. "1". Durch den Codierungsbus $C_0$ bis $C_8$ wird die Adresse $R_{0..7}$, $\overline{R_{0..7}}$ der zu ersetzenden Spalte erzeugt. Gleichzeitig wird RDA log. "0". Wenn alle $R_i$ und $A'_i$ bzw. $\overline{R_i}$ (i=0..7) gleich sind, werden alle $RK'_i$ log. "0". Alle n-Kanal-Transistoren $N'_0$ bis $N'_7$ sperren daher.

Durch die fallende RDA-Flanke wird das vierte Steuersignal ATDN erzeugt, welcher nach einem Zeitintervall T' log. "1" wird. Da alle n-Kanal-Transistor $N'_{0..7}$ sperren, steigt der Knoten $K'_3$ in diesem Zeitintervall T' auf log. "1". Durch die Rückhalteschaltung des Inverters $I'_3$ bleibt in diesem Zeitintervall $K'_3$ auch auf dann auf dem Pegel log. "1", wenn das vierte Steuersignal ATDN auf den Wert log. "0" gesunken ist. Dadurch wird das Redundanzfreigabesignal RN0 log. "0". Wenn das Freigabesignal FR log. "1" wird, schaltet der redundante Signal $RCD_0$ ein, und das Steuersignal RSR0 das redundanten Bitschalter RBS wird log. "1". Gleichzeitig bleibt CFR log. "0", und der normale Spaltendecoder CDEC bleibt verriegelt.

Im Normalfall, d. h. wenn die Adressen $A'_{0..7}$ und $R_{0..7}$ nicht übereinstimmen, ist mindestens eine $A'_i$ nicht gleich $R_i$. Dadurch bleibt mindestens ein Knoten $RK'_i$ log. "1". Wenn RDA log. "0" wird, und das vierte Steuersignal ATDN log. "1" wird, ist zwar das Potential des Knotens $K'_3$ gestiegen, aber durch den leitenden n-Kanal-Transistor $N'_i$ ist das Potential nicht genügend gestiegen, um den rückhaltegeschalteten Inverter $I'_3$ umzuschalten. Daher bleibt $K'_3$ auf log. "0" nach dem ATDN, und RN0 bleibt auf log. "1". Der redundante Spaltendecoder $RCD_0$ bleibt verriegelt. Wenn das Freigabesignal FR log. "1" wird, steigt CFR auf log. "1", und der normale Spaltendecoder CDEC wird aktiviert.

Obwohl in den Beispielen jeweils nur eine Zeile bzw. Spalte mittels der erfindungsgemäßen Redundanz-Schaltungsanordnung ersetzbar wird, ist auch ohne weiteres eine Gruppe von z.B. 2, 4 oder 8 Zeilen bzw. .Spalten gleichzeitig ersetzbar. In diesem Fall sind die in den Adreßdekodern FSO-FS7 gespeicherten Innenblockadressen 1, 2 oder 3 Bits kürzer. Die oben beschriebenen Ausführungsmeßbeispiele sind daher so zu verstehen, daß eine beliebige Gruppe von Zeilen bzw. Spalten durch die Innenblockadresse adressierbar ist, obwohl in den Ausführungsbeispielen jeweils nur eine Zeile bzw. eine Spalte adressiert ist.

Die erfindungsgemäße Redundanz-Schaltungsanordnung läßt sich auch unabhängig von der Speicherarchitektur wie die Aufteilung in Speicherblökke verwenden. Statt wie in den Ausführungsbeispielen oben jede Adreßschaltung einer Blockadresse zuordnen, kann man im allgemeinen jede Adreßschaltung einer ersten Teiladresse der vollen Adresse einer Gruppe von Speicherzellen zuordnen. Die zweite Teiladresse, d.h. der Rest der vollen Adresse, wird in den Adreßschaltungen kodiert, beispielsweise mittels trennbarer Verbindungen wie z.B. Laser Fuses. So kann z.B. jede Adreßschaltung jeweils zwei Speicherblöcken zugeordnet werden, wenn in einem Speicher mit z.B. 8 Speicherblöcken und 4 Adreßschaltungen nur zwei Adreßleitungen $A_8$, $A_9$ der Blockadresse $A_8$, $A_9$, $A_{10}$ zur Auswahl der Adreßschaltung verwendet werden. Die dritte Blockadreßleitung, z.B. $A_{10}$, kann zusätzlich in den Adreßdekodern FS0-FS7 verwendet werden, wobei der Adreßvergleich AV1, AV2 eine zusätzliche Adreßleitung bekommt. Somit sind mittels einer einzigen aktiven Adreßschaltung z.B. FS2, Gruppen von Speicherzellen wahlweise in zwei verschiedenen Speicherblöcken ersetzbar. Umgekehrt können auch mehrere Adreßschaltungen einem oder mehreren Speicherblöcken gemeinsam zugeordnet werden, um daher eine Art blockfreier Redundanz zu schaffen. Bei einer angelegten Adresse ist immer nur eine Adreßschaltung aktiviert werden. Daher muß die Bitweite n1 der ersten Teiladresse der Anzahl M der Adreßschaltungen so gewählt sein, daß $M \leq 2^{n1}$.

**Patentansprüche**

1. Redundanz-Schaltungsanordnung für einen integrierten Halbleiterspeicher mit normalen und redundanten Speicherzellen, bei dem die Adressen ($A_{0..10}$; $A'_{0..10}$) beliebiger Gruppen von Speicherzellen des Speichers aus einer ersten Teiladresse ($A_{8..10}$; $A'_{8..10}$) und einer zweiten Teiladresse ($A_{0..7}$; $A'_{0..7}$) gebildet sind,

- mit M fest programmierbaren Adreßschaltungen (FS0..FS7), wobei $M \geq 1$, wobei jede fest programmierbare Adreßschaltung (FS0..FS7) jeweils einer der ersten Teiladressen ($A_{8...10}$; $A'_{8...10}$) zugeordnet ist, und wobei jede fest programmierbare Adreßschaltung (FS0..FS7) nach dem sie programmiert wurde bei einem aktivierten Zustand die zweite Teiladresse ($R_{0..7}$) einer zu ersetzenden Gruppe von normalen Speicherzellen und einen ersten Ausgang ($c_8$) aufweist, auf dem bei aktiviertem Zustand der Adreßschaltung (FS0..FS7) ein Aktiviersignal (RDA) angelegt wird, wenn die an die Schaltungsanordnung angelegte erste Teiladresse ($A_{8..10}$; $A'_{8..10}$) mit der der Adreßschaltung ($FS_i$) zugeordneten ersten Teiladresse übereinstimmt,
- mit einem allen Adreßschaltungen (FS0..FS7) gemeinsamen Adreßvergleicher (AV1; AV2), der bei angelegten Aktiviersignal (RDA) einer Adreßschaltung (FS0..FS7) die in dieser Adreßschaltung gespeicherte zweite Teiladresse ($R_{0..7}$) mit der angelegten zweiten Teiladresse ($A_{0..7}$; $A'_{0..7}$) vergleicht, wobei bei Übereinstimmung dieser beiden zweiten Teiladressen ein Freigabesignal (RSP; RN0) an einem ersten Ausgang (20; 20') des Adreßvergleichers (AV1; AV2) angelegt wird, wobei das Freigabesignal (RSP; RN0) der Ansteuerung von Redundanzdecodern (RRDEC; RCD$_0$) und der Verriegelung von normalen Decodern dient.

2. Redundanz-Schaltungsanordnung nach Anspruch 1, wobei jede Adreßschaltung (FS0..FS7) durch N+1 trennbare Verbindungen ($F_0..F_8$) programmierbar ist, wobei N die Bitweite der zweiten Teiladresse ($A_{0..7}$; $A'_{0..7}$) ist.

3. Redundanz-Schaltungsanordnung nach einem der Ansprüche 1 oder 2, wobei der Adreßvergleicher (AV1; AV2) durch einen lokalen Codierbus ($C_0...C_8$)

mit allen Adreßschaltungen (FS0..FS7) verbunden ist, wobei der lokale Codierbus die in den Adreßschaltungen gespeicherten zweiten Teiladressen ($R_{0..7}$, $\overline{R_{0..7}}$) und das Aktiviersignal (RDA) an den Adreßvergleicher (AV1; AV2) vermittelt.

4. Redundanz-Schaltungsanordnung nach Anspruch 2, wobei jede Adreßschaltung (FS0..FS7) N Serienschaltungen von jeweils einem auftrennbaren Sicherungselement ($F_{0..7}$) und einem ersten Feldeffekttransistor ($TN_{0..7}$) aufweisen, wobei die Serienschaltungen jeweils zwischen einem ersten Versorgungspotential (VSS) und einem jeweiligen ersten Knotenpunkt ($C_0..C_7$) geschaltet sind, wobei die ersten Knotenpunkte ($C_0..C_7$) und der erste Ausgang ($C_8$) einen lokalen Codierbus bilden, wobei einander entsprechende Sicherungselemente ($F_{0..7}$) der Adreßschaltungen mit denselben Knotenpunkten verbunden sind, wobei jeder erste Knotenpunkt ($C_{0..7}$) jeweils über einen zweiten Feldeffekttransistor ($TP_{0..7}$) an einem zweiten Versorgungspotential (VDD) und jeweils einem Eingang eines ersten Inverters ($I_{10}..I_{17}$) angeschlossen ist, wobei den Steueranschlüssen der ersten Feldeffekttransistoren ($TN_{0..7}$) ein erstes Steuersignal ($K_2$) zugeführt ist, wobei den Steueranschlüssen der zweiten Feldeffekttransistoren ($TP_{0..7}$) ein zweites Steuersignal (PRCH) zugeführt ist, wobei jeder erste Knotenpunkt ($C_0..C_7$) einen ersten Adreßausgang ($R_{0..7}$) bildet, und jeder Ausgang der ersten Inverter ($I_{10..17}$) einer zu dem jeweiligen ersten Adreßausgang komplementären Adreßausgang ($\overline{R_{0..7}}$) bildet.

5. Redundanz-Schaltungsanordnung nach einem der Ansprüche 1 bis 4, wobei der Adreßvergleicher (AV1; AV2) N dritte Feldeffekttransistoren ($N_0...N_7$; $N'_0...N'_7$) aufweist, wo N die Bitweite der zweiten Teiladresse ($A_{0..7}$; $A'_{0..7}$) ist, wobei die jeweiligen Laststrecken der dritten Feldeffekttransistoren ($N_{0...7}'$, $N'_0..N'_7$) zwischen einem dritten Knotenpunkt ($K_3$; $K'_3$) und einem ersten Versorgungspotential (VSS) geschaltet sind, deren Steuereingänge jeweils an einen von N vierten Knotenpunkten ($RK_{0..7}$; $RK'_{0..7}$) geschaltet sind, wobei jedem vierten Knotenpunkt ein vierter ($N_{01}..N_{71}$; $N'_{01}..N'_{71}$) und ein fünfter ($N_{02}...N_{72}$; $N'_{02}...N'_{72}$) Feldeffekttransistor zugeordnet ist, wobei die Laststrecke jedes vierten Feldeffekttransistors ($N_{01}...N_{71}$; $N'_{01}...N'_{71}$) zwischen den zugeordneten vierten Knotenpunkt ($RK_{0..7}$, $RK'_{0..7}$) und einer zugeordneten Adreßleitung der angelegten Adresse ($A_{0...7}$; $A'_{0...7}$) geschaltet ist, wobei die Laststrecke des entsprechenden fünften Feldeffekttransistors ($N_{02}...N_{72}$; $N'_{02}...N'_{72}$) zwischen den zugeordneten vierten Knotenpunkt ($RK_{0..7}$, $RK'_{0..7}$) und einer zur jeweiligen zugeordneten Adreßleitung ($A_0...7$; $A'_{0...7}$) komplementären Adreßleitung ($\overline{A_{0...7}}$; $\overline{A'_{0...7}}$) ge-

schaltet ist, wobei dem Steueranschluß eines jeweiligen vierten Feldeffekttransistors ($N_{01}...N_{71}$; $N'_{01}...N'_{71}$) eine jeweilige Adreßleitung ($R_{0...7}$) der in den Adreßschaltungen (FS0...FS7) gespeicherten zweiten Teiladresse zugeführt ist, wobei der Steueranschluß eines jeweiligen fünften Feldeffekttransistors ($N_{02}...N_{72}$; $N'_{02}...N'_{72}$) eine zur jeweiligen Adreßleitung der in den Adreßschaltungen gespeicherten zweiten Teiladresse komplementären Adreßleitung ($\overline{R_{0...7}}$) zugeführt ist, wobei der Adreßvergleicher (AV1; AV2) eine Haltestufe ($I_3$; $I'_3$) aufweist, deren Eingangsanschluß mit dem dritten Knotenpunkt ($K_3$; $K'_3$) verbunden ist und an deren Ausgangsanschluß das erste Freigabesignal (RSP; RN0) abgreifbar ist, und wobei der Adreßvergleicher (AV1; AV2) eine Aktivierstufe (RBW; RBW') aufweist, deren Ausgangssignal dem dritten Knotenpunkt ($K_3$; $K'_3$) beaufschlagt ist.

6. Redundanz-Schaltung nach Anspruch 5, wobei die Aktivierstufe (RBW) aus einer Serienschaltung von einem sechsten ($T_6$) und siebten ($T_7$) Feldeffekttransistor besteht, wobei die Serienschaltung zwischen dem ersten (VSS) und einem zweiten (VDD) Bezugspotential geschaltet ist, wobei dem Steueranschluß des sechsten Feldeffekttransistors ($T_6$) ein drittes Steuersignal (RST) zugeführt ist, wobei dem Steueranschluß des siebten Feldeffekttransistors ($T_7$) das Aktiviersignal (RDA) der Adreßschaltungen (FS0...FS7) zugeführt ist, wobei der Knotenpunkt (K) zwischen den Laststrecken des sechsten und siebten Feldeffekttransistors Teil des dritten Knotenpunktes ($K_3$) ist.

7. Redundanz-Schaltung nach Anspruch 6, wobei die Schaltungsanordnung eine Schaltung (RTSG) zur Erzeugung des dritten Steuersignals (RST) aufweist, die eine Serienschaltung von vier aufeinanderfolgenden Inverterstufen ($I_{R1}...I_{R4}$) aufweist, wobei dem Eingang der Serienschaltung das Aktiviersignal (RDA) der Adreßschaltungen (FS0..FS7) zugeführt ist, wobei der Ausgang ($K_8$) der Serienschaltung an einem ersten Eingang eines NAND-Gatters ($NAND_1$) angeschlossen ist, wobei der zweite Eingang des NAND-Gatters an dem Knotenpunkt ($K_7$) zwischen der ersten ($I_{R1}$) und der zweiten ($I_{R2}$) Inverterstufe angeschlossen ist, wobei am Ausgang des NAND-Gatters das dritte Steuersignal (RST) abgreifbar ist, und wobei ein Kondensator (C) zwischen dem ersten Versorgungspotential (VSS) und dem Knotenpunkt ($K_9$) zwischen der zweiten und der dritten Inverterstufe ($I_{R2}$, $I_{R3}$) geschaltet ist.

8. Redundanz-Schaltungsanordnung nach Anspruch 5, wobei die Aktivierstufe (RBW; RBW') einen neunten Feldeffekttransistor ($T_9$, $T'_9$) und eine Serienschaltung von einem zehnten und einem elften Feldeffekttransistor ($T_{10}$, $T_{11}$; $T'_{10}$, $T'_{11}$) aufweist, wobei die Serienschaltung zwischen einem zweiten Versorgungspotential (VDD) und dem dritten Knotenpunkt ($K_3$; $K'_3$) geschaltet ist, wobei die Laststrecke des neunten Feldeffekttransistors ($T_9$; $T'_9$) zwischen dem dritten Knotenpunkt ($K_3$; $K'_3$) und dem ersten Versorgungspotential (VSS) geschaltet ist, wobei der neunte und der elfte Feldeffekttransistor ($T_9$, $T_{11}$; $T'_9$, $T'_{11}$) vom zueinander komplementären Leitungstyp sind, wobei den Steueranschlüssen des neunten und elften Feldeffekttransistors ($T_9$, $T_{11}$; $T'_9$, $T'_{11}$) das Aktiviersignal (RDA) der Adreßschaltungen (FS0...FS7) zugeführt ist, und wobei dem Steueranschluß des zehnten Feldeffekttransistors ($T_{10}$; $T'_{10}$) ein viertes Steuersignal (RDADN; ATDN) zugeführt ist.

9. Redundanz-Schaltungsanordnung nach einem der Ansprüche 1 bis 8, wobei die Speicherzellen in M Speicherblöcken ($BK_{0...7}$) angeordnet sind, wobei die Speicherblöcke ($BK_{0...7}$) durch eine Blockadresse ($A_{8...10}$; $A'_{8...10}$) aufrufbar sind, und die Speicherzellen innerhalb eines Speicherblocks durch eine Innenblockadresse ausrufbar sind, wobei M $\geq$ 1, bei dem die erste Teiladresse die Blockadresse ist, und die zweite Teiladresse die Innenblockadresse ist, wobei jede fest programmierbare Adreßschaltung (FS0-FS7) jeweils einem der M Speicherblöcke ($BK_{0...7}$) zugeordnet ist.

10. Redundanz-Schaltungsanordnung nach einem der Ansprüche 1 bis 9, wobei der Halbleiterspeicher ein dynamischer Direktzugriffshalbleiterspeicher (DRAM) ist.

**Claims**

1. Redundancy circuit arrangement for an integrated semiconductor memory having normal and redundant memory cells, in which the addresses ($A_{0..10}$; $A'_{0..10}$) of any desired groups of memory cells of the memory are formed from a first partial address ($A_{8..10}$; $A'_{8..10}$) and a second partial address ($A_{0..7}$; $A'_{0..7}$),

   - having M permanently programmable address circuits (FS0..FS7), where M $\geq$ 1, where each permanently programmable address circuit (FS0..FS7) is respectively assigned to one of the first partial addresses ($A_{8...10}$; $A'_{8...10}$), and where each permanently programmable address circuit (FS0..FS7), after it has been programmed, has, in an activated state, the second partial address ($R_{0..7}$) of a group of normal memory cells that is to be replaced and a first output (c8), on which, in the activated state of the address circuit (FS0..FS7), an activation signal (RDA) is applied if the first partial address ($A_{8..10}$; $A'_{8..10}$) applied to the circuit arrangement corresponds to the first partial address assigned to the address circuit ($FS_i$),

- having an address comparator (AV1; AV2), which is shared by all the address circuits (FS0..FS7) and, given an applied activation signal (RDA) of an address circuit (FS0..FS7), compares the second partial address ($R_{0..7}$), stored in this address circuit, with the applied second partial address ($A_{0..7}$; $A'_{0..7}$), in which case, in the event of correspondence between these two second partial addresses, an enable signal (RSP; RN0) is applied at a first output (20; 20') of the address comparator (AV1; AV2), the enable signal (RSP; RN0) serving to drive redundancy decoders (RRDEC; $RCD_0$) and to latch normal decoders.

2. Redundancy circuit arrangement according to Claim 1, where each address circuit (FS0..FS7) can be programmed by N+1 fuses ($F_0..F_8$), where N is the bit width of the second partial address ($A_{0..7}$; $A'_{0..7}$).

3. Redundancy circuit arrangement according to either of Claims 1 and 2, where the address comparator (AV1; AV2) is connected to all the address circuits (FS0..FS7) by a local coding bus ($C_0...C_8$), where the local coding bus communicates the second partial addresses ($R_{0..7}$, $\overline{R_{0..7}}$) stored in the address circuits and the activation signal (RDA) to the address comparator (AV1; AV2).

4. Redundancy circuit arrangement according to Claim 2, where each address circuit (FS0..FS7) has N series circuits formed by a respective fuse element ($F_{0..7}$) and a first field-effect transistor ($TN_{0..7}$), where the series circuits are respectively connected between a first supply potential (VSS) and a respective first node ($C_0..C_7$), where the first nodes ($C_0..C_7$) and the first output (C8) form a local coding bus, where mutually corresponding fuse elements ($F_{0..7}$) of the address circuits are connected to the same nodes, where each first node ($C_{0..7}$) is respectively connected via a second field-effect transistor ($TP_{0..7}$) to a second supply potential (VDD) and to a respective input of a first inverter ($I_{10..}I_{17}$), where a first control signal ($K_2$) is fed to the control terminals of the first field-effect transistors ($TN_{0..7}$), where a second control signal (PRCH) is fed to the control terminals of the second field-effect transistors ($TA_{0..7}$), where each first node ($C_0..C_7$) forms a first address output ($R_{0..7}$), and each output of the first inverters ($I_{10..17}$) forms a complementary address output ($\overline{R_{0..7}}$) with respect to the respective first address output.

5. Redundancy circuit arrangement according to one of Claims 1 to 4, where the address comparator (AV1; AV2) has N third field-effect transistors ($N_0...N_7$; $N'_0...N'_7$), where N is the bit width of the second partial address ($A_{0..7}$; $A'_{0..7}$), where the respective load paths of the third field-effect transistors ($N_{0...7}$, $N'_0..N'_7$) are connected between a third node ($K_3$; $K'_3$) and a first supply potential (VSS), the control inputs of which are respectively connected to one of N fourth nodes ($RK_{0...7}$; $RK'_{0...7}$), where each fourth node is assigned a fourth ($N_{01}..N_{71}$; $N'_{01}..N'_{71}$) and a fifth ($N_{02}...N_{72}$; $N'_{02}...N'_{72}$) field-effect transistor, where the load path of each fourth field-effect transistor ($N_{01}...N_{71}$; $N'_{01}..N'_{71}$) is connected between the assigned fourth node ($RK_{0...7}$, $RK'_{0...7}$) and an assigned address line of the applied address ($A_{0...7}$; $A'_{0...7}$), where the load path of the corresponding fifth field-effect transistor ($N_{02}...N_{72}$; $N'_{02}...N'_{72}$) is connected between the assigned fourth node ($RK_{0...7}$, $RK'_{0...7}$) and a complementary address line ($\overline{A_{0...7}}$; $\overline{A'_{0...7}}$) with respect to the respective assigned address line ($A_{0...7}$; $A'_{0...7}$), where a respective address line ($R_{0...7}$) of the second partial address stored in the address circuits (FS0...FS7) is fed to the control terminal of a respective fourth field-effect transistor ($N_{01}...N_{71}$; $N'_{01}..N'_{71}$), where a complementary address line ($\overline{R_{0..7}}$) with respect to the respective address line of the second partial address stored in the address circuits is fed to the control terminal of a respective fifth field-effect transistor ($N_{02}...N_{72}$; $N'_{02}...N'_{72}$), where the address comparator (AV1; AV2) has a holding stage ($I_3$; $I'_3$), whose input terminal is connected to the third node ($K_3$; $K'_3$) and at whose output terminal the first enable signal (RSP; RN0) can be picked off, and where the address comparator (AV1; AV2) has an activation stage (RBW; RBW'), whose output signal is applied to the third node ($K_3$; $K'_3$).

6. Redundancy circuit according to Claim 5, where the activation stage (RBW) comprises a series circuit formed by a sixth ($T_6$) and seventh (T7) field-effect transistor, where the series circuit is connected between the first (VSS) and a second (VDD) reference potential, where a third control signal (RST) is fed to the control terminal of the sixth field-effect transistor ($T_6$), where the activation signal (RDA) of the address circuits (FS0...FS7) is fed to the control terminal of the seventh field-effect transistor ($T_7$), where the node (K) between the load paths of the sixth and seventh field-effect transistors is part of the third node ($K_3$).

7. Redundancy circuit according to Claim 6, where the circuit arrangement has a circuit (RTSG) for generating the third control signal (RST), which circuit has a series circuit formed by four successive inverter stages ($I_{R1}..I_{R4}$), where the activation signal (RDA) of the address circuits (FS0..FS7) is fed to the input of the series circuit, where the output ($K_8$) of the series circuit is connected to a first input of a NAND gate ($NAND_1$), where the second input of the NAND gate is connected to the node ($K_7$) between the first ($I_{R1}$) and the second ($I_{R2}$) inverter stage, where the third control signal (RST) can be picked off at the output of the NAND gate, and where a capacitor (C) is connected between the first supply potential (VSS) and the node ($K_9$) between the second and third inverter stages ($I_{R2}$, $I_{R3}$).

8. Redundancy circuit arrangement according to Claim 5, where the activation stage (RWB; RWB') has a ninth field-effect transistor ($T_9$, $T'_9$) and a series circuit formed by a tenth and an eleventh field-effect transistor ($T_{10}$, $T_{11}$; $T'_{10}$, $T'_{11}$), where the series circuit is connected between a second supply potential (VDD) and the third node ($K_3$; $K'_3$), where the load path of the ninth field-effect transistor ($T_9$; $T'_9$) is connected between the third node ($K_3$; $K'_3$) and the first supply potential (VSS), where the ninth and the eleventh field-effect transistor ($T_9$, $T_{11}$; $T'_9$, $T'_{11}$) are of mutually complementary conduction types, where the activation signal (RDA) of the address circuits (FS0...FS7) is fed to the control terminals of the ninth and eleventh field-effect transistors ($T_9$, $T_{11}$; $T'_9$, $T'_{11}$), and where a fourth control signal (RDADN; ATDN) is fed to the control terminal of the tenth field-effect transistor ($T_{10}$; $T'_{10}$).

9. Redundancy circuit arrangement according to one of Claims 1 to 8, where the memory cells are arranged in M memory blocks ($BK_{0...7}$), where the memory blocks ($BK_{0...7}$) can be called up by a block address ($A_{8...10}$; $A'_{8...10}$), and the memory cells within a memory block can be called by an internal block address, where M ≥ 1, in which the first partial address is the block address, and the second partial address is the internal block address, where each permanently programmable address circuit (FS0-FS7) is respectively assigned to one of the M memory blocks ($BK_{0...7}$).

10. Redundancy circuit arrangement according to one of Claims 1 to 9, where the semiconductor memory is a dynamic direct access semiconductor memory (DRAM).

**Revendications**

1. Circuit de redondance pour une mémoire à circuit intégré à semi-conducteur avec cellules de mémoire normales et redondantes, dans lequel les adresses ($A_{0...10}$; $A'_{0...10}$) de groupes quelconques de cellules de mémoire de la mémoire sont constituées d'une première adresse partielle ($A_{8...10}$; $A'_{8...10}$) et d'une deuxième adresse partielle ($A_{0...7}$; $A'_{0...7}$),

- comportant M circuits d'adressage à programmation fixe (FS0...FS7), où M ≥ 1, chaque circuit d'adressage à programmation fixe (FS0... FS7) étant respectivement attribué à l'une des premières adresses partielles ($A_{8...10}$; $A'_{8...10}$), et chaque circuit d'adressage à programmation fixe (FS0...FS7), après qu'il a été programmé, présente lorsqu'il est activé la deuxième adresse partielle ($R_{0...7}$) d'un groupe à remplacer de cellules de mémoire normales et présente une première sortie ($c_8$), sur laquelle un signal d'activation (RDA) est appliqué lorsque le circuit d'adressage (FS0...FS7) est activé, lorsque la première adresse partielle ($A_{8...10}$; $A'_{8...10}$) appliquée au circuit d'adressage correspond à la première adresse partielle attribuée au circuit d'adressage ($FS_i$),
- comportant un comparateur d'adresses (AV1; AV2) commun pour tous les circuits d'adressage (FS0...FS7) qui, à l'application du signal d'activation (RDA) d'un circuit d'adressage (FS0...FS7), compare la deuxième adresse partielle ($R_{0...7}$) mémorisée dans ce circuit d'adressage à la deuxième adresse partielle appliquée ($A_{0...7}$; $A'_{0...7}$), un signal de libération (RSP; RN0) étant appliqué à une première sortie (20; 20') du comparateur d'adresses (AV1; AV2) en cas de correspondance de ces deux deuxièmes adresses partielles, le signal de libération (RSP; RN0) servant à la commande de décodeurs redondants (RRDEC; $RCD_0$) et au verrouillage de décodeurs normaux.

2. Circuit de redondance suivant la revendication 1, dans lequel chaque circuit d'adressage (FS0...FS7) peut être programmé à l'aide de N+1 liaisons séparables ($F_0...F_8$), N étant la largeur en bits de la deuxième adresse partielle ($A_{0...7}$; $A'_{0...7}$).

3. Circuit de redondance suivant l'une des revendications 1 ou 2, le comparateur d'adresses (AV1; AV2) étant relié par un bus de codage local ($C_0...C_8$) à tous les circuits d'adressage (FS0...FS7), le bus de codage local transmettant les deuxièmes adresses partielles ($R_{0...7}$; $\overline{R_{0...7}}$) mémorisées dans les circuits d'adressage et le signal d'activation (RDA) au comparateur d'adresses (AV1; AV2).

4. Circuit de redondance suivant la revendication 2, dans lequel chaque circuit d'adressage (FS0...FS7) présente N circuits en série comprenant chacun un élément de sauvegarde séparable ($F_{0...7}$) et un premier transistor à effet de champ ($TN_{0...7}$), les circuits en série étant branchés chacun entre un premier potentiel d'alimentation (VSS) et un premier noeud

respectif ($C_0...C_7$), les premiers noeuds ($C_0...C_7$) et la première sortie ($C_8$) formant un bus de codage local, des éléments de sauvegarde ($F_{0...7}$) en correspondance mutuelle des circuits d'adressage étant reliés aux mêmes noeuds, chaque premier noeud ($C_{0...7}$) étant chaque fois raccordé via un deuxième transistor à effet de champ ($TP_{0...7}$) à un deuxième potentiel d'alimentation (VDD) et à une entrée respective d'un premier inverseur ($I_{10}...I_{17}$), un premier signal de commande ($K_2$) étant appliqué aux raccords de commande des premiers transistors à effet de champ ($TN_{0...7}$), un deuxième signal de commande (PRCH) étant appliqué aux raccords de commande des deuxièmes transistors à effet de champ ($TP_{0...7}$), chaque premier noeud ($C_0...C_7$) constituant une première sortie d'adressage ($R_{0...7}$) et chaque sortie des premiers inverseurs ($I_{10}...I_{17}$) constituant une sortie d'adressage complémentaire de la première sortie d'adressage $\overline{R_{0...7}}$ correspondante.

5. Circuit de redondance suivant l'une des revendications 1 à 4, le comparateur d'adresses (AV1; AV2) présentant N troisièmes transistors à effet de champ ($N_0...N_7$; $N'_0...N'_7$), où N est la largeur en bits de la deuxième adresse partielle ($A_{0...7}$; $A'_{0...7}$), les chemins de charge respectifs des troisièmes transistors à effet de champ ($N_{0...7}$; $N'_0...N'_7$) étant branchés entre un troisième noeud ($K_3$; $K'_3$) et un premier potentiel d'alimentation (VSS) dont les entrées de commande sont branchées respectivement à un noeud parmi N quatrièmes noeuds ($RK_{0...7}$; $RK'_{0...7}$), un quatrième ($N_{01}...N_{71}$; $N'_{01}...N'_{71}$) et un cinquième ($N_{02}...N_{72}$; $N'_{02}...N'_{72}$) transistors à effet de champ étant attribués à chaque quatrième noeud, le chemin de charge de chaque quatrième transistor à effet de champ ($N_{01}...N_{71}$; $N'_{01}...N'_{71}$) étant branché entre le quatrième noeud correspondant ($RK_{0...7}$; $RK'_{0...7}$) et une ligne d'adressage correspondante de l'adresse appliquée ($A_{0...7}$; $A'_{0...7}$), le chemin de charge du cinquième transistor à effet de champ correspondant ($N_{02}...N_{72}$; $N'_{02}...N'_{72}$) étant branché entre le quatrième noeud correspondant ($RK_{0...7}$; $RK'_{0...7}$) et une ligne d'adressage ($A_{0...7}$, $A'_{0...7}$) complémentaire de la ligne d'adressage appliquée respective ($\overline{A_{0...7}}$; $\overline{A'_{0...7}}$), une ligne d'adressage respective ($R_{0...7}$) de la deuxième adresse partielle mémorisée dans les circuits d'adressage (FS0...FS7) étant amenée au raccordement de commande d'un quatrième transistor à effet de champ correspondant ($N_{01}...N_{71}$; $N'_{01}...N'_{71}$), une ligne d'adressage ($\overline{R_{0...7}}$) complémentaire de la deuxième adresse partielle mémorisée dans les circuits d'adressage étant amenée au raccordement de commande d'un cinquième transistor à effet de champ correspondant ($N_{02}...N_{72}$; $N'_{02}...N'_{72}$), le comparateur d'adresses (AV1; AV2) présentant un étage d'arrêt

($I_3$; $I'_3$) dont le raccordement d'entrée est relié au troisième noeud ($K_3$; $K'_3$) et au raccordement de sortie duquel le premier signal de libération (RSP; RN0) peut être prélevé, et le comparateur d'adresses (AV1; AV2) présentant un étage d'activation (RBW; RBW'), dont le signal de sortie est appliqué au troisième noeud ($K_3$; $K'_3$).

6. Circuit de redondance suivant la revendication 5, dans lequel l'étage d'activation (RBW) est constitué d'un circuit en série d'un sixième ($T_6$) et d'un septième ($T_7$) transistors à effet de champ, le circuit en série étant branché entre le premier (VSS) et un deuxième (VDD) potentiels de référence, un troisième signal de commande (RST) étant amené au raccordement de commande du sixième transistor à effet de champ ($T_6$), le signal d'activation (RDA) des circuits d'adressage (FS0...FS7) étant amené au raccordement de commande du septième transistor à effet de champ ($T_7$), le noeud (K) entre les chemins de charge des sixième et septième transistors à effet de champ faisant partie du troisième noeud ($K_3$).

7. Circuit de redondance suivant la revendication 6, dans lequel le circuit présente un circuit (RTSG) de production du troisième signal de commande (RST), qui comprend un circuit en série de quatre étages d'inversion successifs ($I_{R1}...I_{R4}$), le signal d'activation (RDA) des circuits d'adressage (FS0...FS7) étant amené à l'entrée du circuit en série, la sortie ($K_8$) du circuit en série étant raccordée à une première entrée d'une grille NAND ($NAND_1$), la deuxième entrée de la grille NAND étant raccordée au noeud ($K_7$) entre le premier ($I_{R1}$) et le deuxième ($I_{R2}$) étage d'inversion, le troisième signal de commande (RST) pouvant être prélevé à la sortie de la grille NAND, et un condensateur (C) étant branché entre le premier potentiel d'alimentation (VSS) et le noeud ($K_9$) entre le deuxième et le troisième étages d'inversion ($I_{R2}$, $I_{R3}$).

8. Circuit de redondance suivant la revendication 5, dans lequel l'étage d'activation (RBW; RBW') présente un neuvième transistor à effet de champ ($T_9$; $T'_9$) et un circuit en série d'un dixième et d'un onzième transistors à effet de champ ($T_{10}$, $T_{11}$; $T'_{10}$, $T'_{11}$), le circuit en série étant branché entre un deuxième potentiel d'alimentation (VDD) et le troisième noeud ($K_3$; $K'_3$), le chemin de charge du neuvième transistor à effet de champ ($T_9$; $T'_9$) étant branché entre le troisième noeud ($K_3$; $K'_3$) et le premier potentiel d'alimentation (VSS), le neuvième et le onzième transistors à effet de champ ($T_9$, $T_{11}$; $T'_9$, $T'_{11}$) étant de types de conduction mutuellement complémentaires, le signal d'activation (RDA) des circuits d'adressage (FS0...FS7) étant amené aux raccordements de commande des neuvième et onzième transistors à effet de champ ($T_9$, $T_{11}$; $T'_9$, $T'_{11}$), et un quatrième signal de commande (RDADN; ATDN) étant amené au raccordement de commande du dixième transistor à effet de champ ($T_{10}$, $T'_{10}$).

9. Circuit de redondance suivant l'une des revendications 1 à 8, dans lequel les cellules de mémoire sont disposées en M blocs de mémoire ($BK_{0...7}$), les blocs de mémoire ($BK_{0...7}$) pouvant être appelés à l'aide d'une adresse de bloc ($A_{8...10}$; $A'_{8...10}$), et les cellules de mémoire à l'intérieur d'un bloc de mémoire pouvant être appelées à l'aide d'une adresse interne de bloc, M étant $\geq 1$, dans lequel la première adresse partielle est l'adresse de bloc et la deuxième adresse partielle est l'adresse interne de bloc, chaque circuit d'adressage à programmation fixe (FS0...FS7) étant attribué respectivement à un des M blocs de mémoire ($BK_{0...7}$).

10. Circuit de redondance suivant l'une des revendications 1 à 9, dans lequel la mémoire à semi-conducteur est une mémoire à semi-conducteur dynamique à accès direct (DRAM).

FIG 1

FIG 2

EP 0 697 659 B1

FIG 3

FIG 4

FIG 5A

FIG 5B

FIG 5C

FIG 5D

VDD

RDADN → $T_{10}$

$T_{11}$ — $K_3$

RDA → $T_9$

VSS

RBW

FIG 5E

RDADNG

RDA → $I'_{R1}$ $I'_{R2}$ $I'_{R3}$ → RDADN

$C'$

VSS

FIG 5F

RDA

RDADN

T

FIG 6

EP 0 697 659 B1

## FIG 7A

## FIG 7B

FIG 8A

FIG 8B